# EUROPEAN PATENT APPLICATION

(11) **EP 3 945 573 A1**
(43) Date of publication of application: **02.02.2022**
(21) Application number: 21179411.0
(22) Date of filing: 15.06.2021
(51) Int. Cl.: H01L 25/075, H01L 33/62, H01L 21/74

(54) **LIGHT-EMITTING DEVICE, LIGHT-EMITTING DISPLAY, AND IMAGE DISPLAY DEVICE**

(30) Priority: 27.07.2020 JP 2020126068
(71) Applicant: Oki Electric Industry Co., Ltd., Minato-ku Tokyo 105-8460 (JP)
(72) Inventor: NAKAI, Yusuke, Tokyo 105-8460 (JP); SUZUKI, Takahito, Tokyo 105-8460 (JP); TANIGAWA, Kenichi, Tokyo 105-8460 (JP); FURUTA, Hironori, Tokyo 105-8460 (JP); JUMONJI, Shinya, Tokyo 105-8460 (JP); MATSUO, Genichiro, Tokyo 105-8460 (JP); ISHIKAWA, Takuma, Tokyo 105-8460 (JP); KAWADA, Hiroto, Tokyo 105-8460 (JP)
(74) Representative: Betten & Resch

(57) **Abstract**

A light emitting device includes a pixel set unit (100) that includes a plurality of pixels (101 - 104) arranged in a grid, first common wiring (157, 158) that connects together first terminals of pixels (101 and 102, or 103 and 104) aligned in a first direction among the plurality of pixels (101 - 104), and second common wiring (151 - 156) that connects together second terminals of two pixels (101 and 103, or 102 and 104) aligned in a second direction orthogonal to the first direction among the plurality of pixels (101 - 104).

## Description

### BACKGROUND OF THE INVENTION

### 1. Field of the Invention

The present invention relates to a light emitting device, a light emitting display, and an image display device including a plurality of light emitting displays.

### 2. Description of the Related Art

Conventionally, there has been proposed an LED display as a light emitting display including a plurality of LEDs (Light Emitting Diodes) arranged two-dimensionally (see Patent Reference 1, for example). This LED display includes an integration substrate and a plurality of multipixel packages (pixel set units) arranged in a grid on the integration substrate. Each pixel set unit includes a package substrate, four pixels arranged in a grid of two rows and two columns on the package substrate, and a plurality of electrode terminals. Each pixel includes three LEDs (subpixels) that respectively emit red (R), green (G) and blue (B) light.

Patent Reference 1: Japanese Patent Application Publication No. 2019-53328 (see Fig. 1 to Fig. 5, for example).

However, since the plurality of electrode terminals are arranged in the vicinity of an outer peripheral edge of the package substrate in the aforementioned LED display, there is a problem in that it is impossible to sufficiently narrow the pixel pitch of pixels adjoining each other between adjoining pixel set units in cases where a plurality of pixel set units are arranged in a grid on the integration substrate.

### SUMMARY OF THE INVENTION

An object of the present invention, which has been made to resolve the above-described problem with the conventional technology, is to provide a light emitting device, a light emitting display and an image display device that make it possible to narrow the pixel pitch of pixels adjoining each other between adjoining pixel set units.

A light emitting device according to an aspect of the present invention includes a pixel set unit that includes a plurality of pixels arranged in a grid, first common wiring that connects together first terminals of pixels aligned in a first direction among the plurality of pixels, and second common wiring that connects together second terminals of two pixels aligned in a second direction orthogonal to the first direction among the plurality of pixels.

According to the present invention, it is possible to narrow the pixel pitch of pixels adjoining each other between adjoining pixel set units.

### BRIEF DESCRIPTION OF THE DRAWINGS

The present invention will become more fully understood from the detailed description given hereinbelow and the accompanying drawings which are given by way of illustration only, and thus are not limitative of the present invention, and wherein:
Fig. 1 is a schematic perspective view showing a configuration of an LED display as a light emitting display according to a first embodiment;
Fig. 2 is a schematic plan view showing a configuration of a light emitting device (including one pixel set unit) according to the first embodiment;
Fig. 3 is a schematic cross-sectional view taken along the line III-III in the light emitting device shown in Fig. 2;
Figs. 4A and 4B are schematic cross-sectional views showing a manufacturing process of the LED display according to the first embodiment (a process of forming a film member and LEDs);
Figs. 5A and 5B are schematic cross-sectional views showing the manufacturing process of the LED display according to the first embodiment (a process of forming a wire and moving the film member);
Fig. 6 is a schematic cross-sectional view showing the manufacturing process of the LED display according to the first embodiment (a process of bonding the film member onto a substrate);
Fig. 7 is a schematic cross-sectional view showing an example of the structure of electrodes and wiring of the substrate in the process of Fig. 6;
Fig. 8 is a schematic cross-sectional view showing a process of connecting driver ICs to the LED display manufactured by the process of Fig. 7;
Fig. 9 is a schematic cross-sectional view showing the LED display to which the driver ICs have been connected;
Fig. 10 is a schematic cross-sectional view showing a state before the LED display to which the driver ICs have been connected and a panel control substrate are coupled together;
Fig. 11 is a schematic cross-sectional view showing a state after the LED display to which the driver ICs have been connected and the panel control substrate are coupled together;
Fig. 12 is a schematic perspective view showing an image display device including a plurality of LED displays arranged in a grid;
Figs. 13A and 13B are schematic plan views showing contact vias in the light emitting device (including one pixel set unit) shown in Fig. 2;
Figs. 14A and 14B are schematic plan views showing the contact vias of four adjoining light emitting devices in four LED displays in the image display device shown in Fig. 12;
Fig. 15 is a schematic perspective view showing an LED display as a light emitting display according to a second embodiment;
Fig. 16 is a schematic plan view showing a light emitting device (including four pixel subset units) according to the second embodiment;
Fig. 17 is a schematic plan view showing the pixel subset unit of the light emitting device shown in Fig. 16; and
Figs. 18A and 18B are schematic plan views showing contact vias in the pixel subset unit shown in Fig. 17.

### DETAILED DESCRIPTION OF THE INVENTION

A light emitting device, a light emitting display, and an image display device according to each embodiment of the present invention will be described below with reference to drawings. In each embodiment, the light emitting display includes a plurality of light emitting devices, and the image display device includes a plurality of light emitting displays. The following embodiments are just examples and a variety of modifications are possible within the scope of the present invention.

### (First Embodiment)

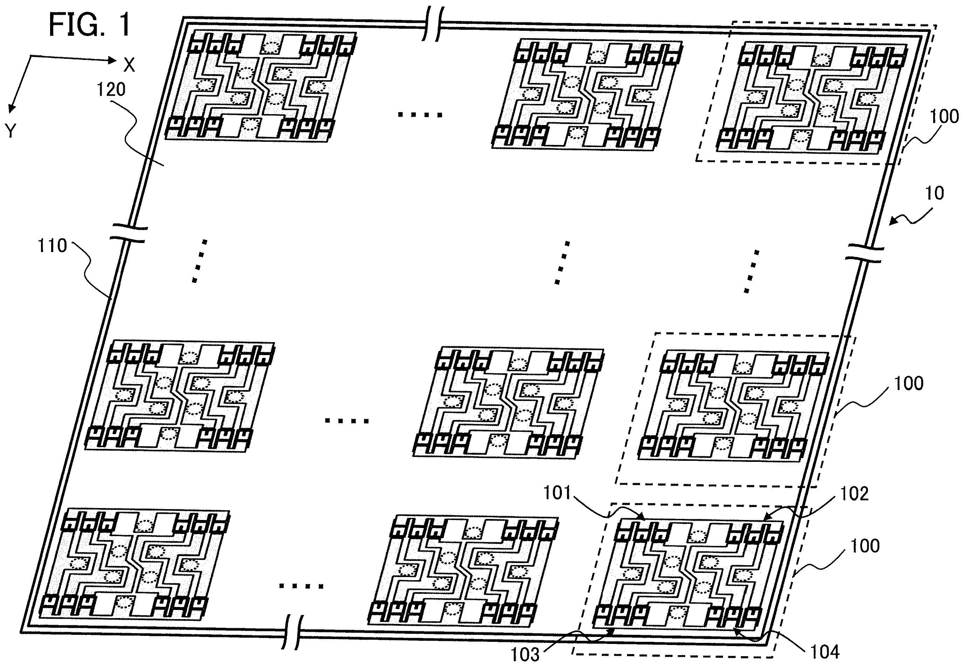

Fig. 1 is a schematic perspective view showing a configuration of an LED display 10 as the light emitting display according to a first embodiment. As shown in Fig. 1, the LED display 10 includes a plurality of pixel set units 100. In Fig. 1, the plurality of pixel set units 100 are arranged in a grid, that is, in a plurality of rows and a plurality of columns, on a film member 120 as a thin-film substrate. In Fig. 1, each pixel set unit 100 includes four pixels 101 to 104 arranged in a grid of two rows and two columns on the film member 120. The film member 120 is arranged on a substrate 110. The substrate 110 is a mounting substrate including electrodes, wiring, circuits, and so forth. In the first embodiment, a two-dimensional shape of the film member 120 is a quadrangular shape, and a two-dimensional shape of the substrate 110 is a quadrangular shape.

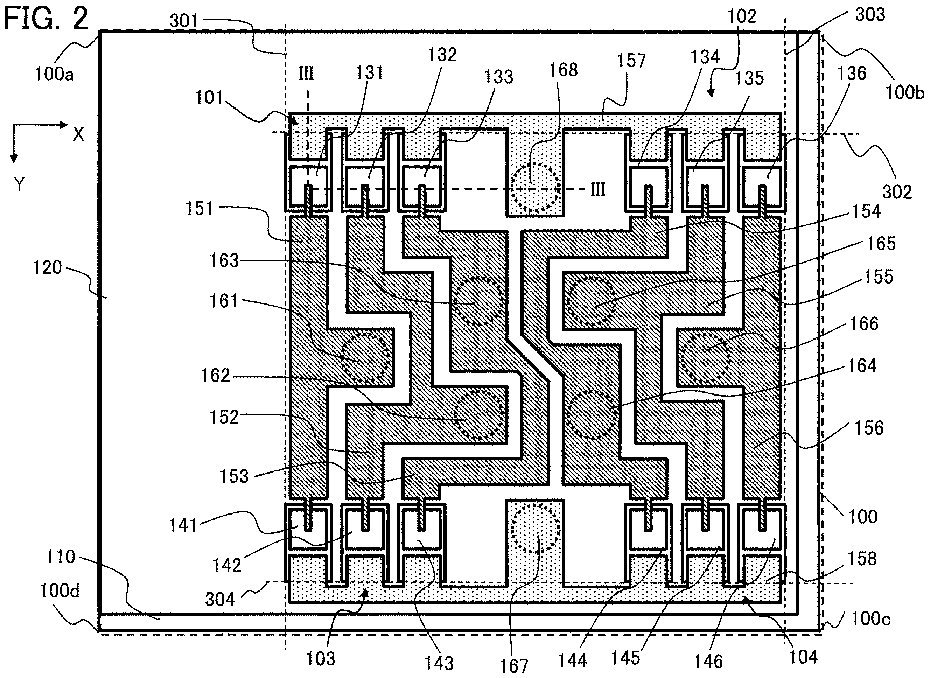

Fig. 2 is a schematic plan view showing a configuration of the light emitting device according to the first embodiment. The light emitting device according to the first embodiment includes one pixel set unit 100. Each pixel set unit 100 includes four pixels 101 to 104 as a plurality of pixels. Incidentally, the number of pixels included in each pixel set unit 100 is not limited to four.

On the film member 120, there is formed a common cathode wire 157 as first common wiring that connects together first terminals of the pixels 101 and 102 aligned in an X direction (horizontal direction in Fig. 2) as a first direction among the four pixels 101 to 104, and there is formed a common cathode wire 158 as first common wiring that connects together first terminals of the pixels 103 and 104 aligned in the X direction among the four pixels 101 to 104. In the first embodiment, the first terminals are cathode terminals.

Further, on the film member 120, there are formed common anode wires 151 to 153 as second common wiring that connects together second terminals of the pixels 101 and 103 aligned in a Y direction (vertical direction in Fig. 2) as a second direction among the four pixels 101 to 104, and there are formed common anode wires 154 to 156 as second common wiring that connects together second terminals of the pixels 102 and 104 aligned in the Y direction among the four pixels 101 to 104. In the first embodiment, the second terminals are anode terminals. Incidentally, it is permissible even if the first terminals are anode terminals and the second terminals are cathode terminals.

The film member 120 is formed with an organic film or an inorganic film. As the organic film, it is possible to use a film made of material such as polyimide, polyamide, polyethylene terephthalate (PET) or polyethylene naphthalate (PEN), for example. As the inorganic film, it is possible to use a film made of material such as SiO₂, Si or Al₂O₃, for example. Film thickness of the film member 120 is approximately 1 µm to 30 µm, for example.

The substrate 110 is, for example, a mounting substrate of PCB (Printed Circuit Board), COF (Chip On Film) or the like.

As shown in Fig. 2, the common cathode wires 157 and 158 and the common anode wires 151 to 156 are formed on the film member 120 without intersecting with each other. Put another way, in the first embodiment, the common cathode wires 157 and 158 extend in the X direction so as not to intersect with each other. In the first embodiment, the common anode wires 151 to 156 extend in the Y direction so as not to intersect with each other. Further, so that the common cathode wires 157 and 158 and the common anode wires 151 to 156 do not intersect with each other, the common anode wires 151 to 156 are arranged in an anode wiring formation region as a region between the pixels 101 and 103 or between the pixels 102 and 104 and the common cathode wires 157 and 158 are arranged in regions other than the anode wiring formation region.

As shown in Fig. 2, each pixel 101 - 104 includes LEDs as light emitting elements serving as subpixels. The pixel 101 includes LEDs 131, 132 and 133 for red color, green color and blue color (i.e., for R, G and B), and the pixel 102 includes LEDs 134, 135 and 136 for R, G and B. The pixel 103 includes LEDs 141, 142 and 143 for R, G and B, and the pixel 104 includes LEDs 144, 145 and 146 for R, G and B. The light emitting element is not limited to an LED but can also be a different type of light emitting element.

Further, in Fig. 2, the LEDs 131, 132 and 133 in the same pixel 101 are arranged linearly in the X direction. However, the arrangement direction of the LEDs 131, 132 and 133 is not limited to the X direction but can also be a direction inclined with respect to the X direction, for example. The arrangement of the LEDs in the other pixels 102, 103 and 104 is the same as the arrangement of the LEDs 131, 132 and 133 in the pixel 101.

While an example in which each pixel 101 - 104 includes three subpixels is shown in Fig. 2, the number of subpixels included in one pixel is not limited to three but can also be four or more, for example.

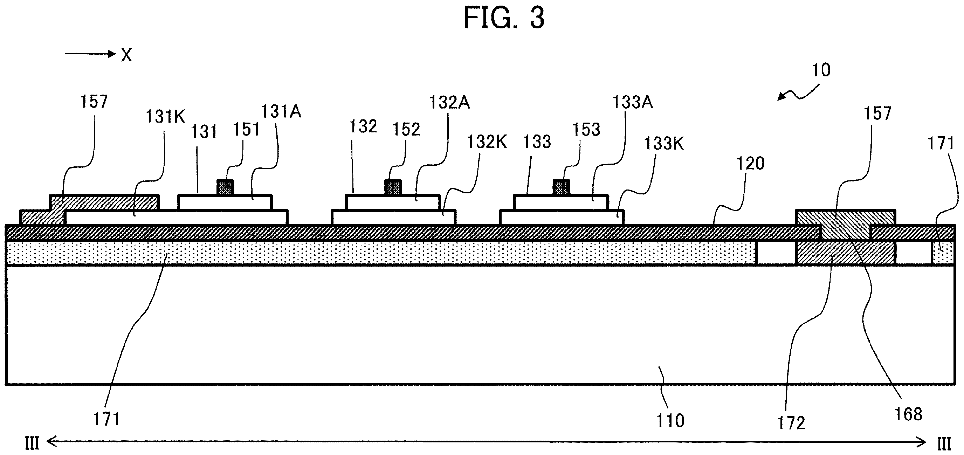

The substrate 110 has a first electrode and a second electrode. The film member 120 has contact vias 167 and 168 as first contact vias and contact vias 161 to 166 as second contact vias. On the substrate 110, the first electrode (e.g., a conductor pattern 172 as an electrode in Fig. 3 which will be explained later) that is electrically connected to the common cathode wires 157 and 158 via the contact vias 167 and 168 and the second electrode that is electrically connected to the common anode wires 151 to 156 via the contact vias 161 to 166 are arranged in a quadrangle formed by straight lines 301 to 304 connecting outer peripheries (i.e., outer sides) of the four pixels 101 to 104 closest to corner parts 100a to 100d of the pixel set unit 100 among the pixels included in the pixel set unit 100.

In Fig. 2, each of the contact vias 161 to 166 is a common anode via, and each of the contact vias 167 and 168 is a common cathode via. An anode terminal of the LED 131 for the red color (for R), an anode terminal of the LED 141 for R, and an anode electrode on the substrate 110 being exposed in the contact via 161 are connected together by the common anode wire 151. An anode terminal of the LED 132 for the green color (for G), an anode terminal of the LED 142 for G, and an anode electrode on the substrate 110 being exposed in the contact via 162 are connected together by the common anode wire 152. An anode terminal of the LED 133 for the blue color (for B), an anode terminal of the LED 143 for B, and an anode electrode on the substrate 110 being exposed in the contact via 163 are connected together by the common anode wire 153.

Similarly, an anode terminal of the LED 134 for R, an anode terminal of the LED 144 for R, and an anode electrode on the substrate 110 being exposed in the contact via 164 are connected together by the common anode wire 154. An anode terminal of the LED 135 for G, an anode terminal of the LED 145 for G, and an anode electrode on the substrate 110 being exposed in the contact via 165 are connected together by the common anode wire 155. An anode terminal of the LED 136 for B, an anode terminal of the LED 146 for B, and an anode electrode on the substrate 110 being exposed in the contact via 166 are connected together by the common anode wire 156.

Further, cathode terminals of the LEDs 131, 132 and 133 for R, G and B, cathode terminals of the LEDs 134, 135 and 136 for R, G and B, and a cathode electrode on the substrate 110 being exposed in the contact via 168 are connected together by the common cathode wire 157. Similarly, cathode terminals of the LEDs 141, 142 and 143 for R, G and B, cathode terminals of the LEDs 144, 145 and 146 for R, G and B, and a cathode electrode on the substrate 110 being exposed in the contact via 167 are connected together by the common cathode wire 158.

As shown in Fig. 2, in the light emitting device according to the first embodiment, the contact vias 161 to 166 and the contact vias 167 and 168 formed in the film member 120 are arranged in the quadrangle formed by the straight lines 301 to 304 connecting the outer peripheries of the four pixels 101 to 104 closest to the corner parts 100a to 100d of the pixel set unit 100. As a result, the common cathode wires 157 and 158 are electrically connected to the cathode electrode of the substrate 110 via the contact vias 167 and 168. The common anode wires 151 to 156 are electrically connected to the anode electrode of the substrate 110 via the contact vias 161 to 166.

Fig. 3 is a schematic cross-sectional view taken along the line III-III in the light emitting device shown in Fig. 2. As shown in Fig. 3, the LED 131 for R includes a cathode layer 131K and an anode layer 131A formed on the cathode layer 131K. The LED 132 for G includes a cathode layer 132K and an anode layer 132A formed on the cathode layer 132K. The LED 133 for B includes a cathode layer 133K and an anode layer 133A formed on the cathode layer 133K. While the LED 131 is formed with two semiconductor layers: the cathode layer 131K and the anode layer 131A, the LED 131 may be formed with three or more semiconductor layers. The other LEDs 134 to 136, 141 to 143 and 144 to 146 forming the pixels 102 to 104 also have the same configuration as the LEDs 131 to 133. Incidentally, the LEDs 131 to 136 and 141 to 146 are obtained by placing a semiconductor epitaxial film, as a semiconductor layer formed on a growth substrate (not shown) by epitaxial growth, on the film member 120. The film member 120 having the LEDs 131 to 136 and 141 to 146, the common cathode wires 157 and 158 and the common anode wires 151 to 156 is bonded onto the conductor pattern 172 and a resist pattern 171 formed on the substrate 110. Incidentally, it is also possible to form the common cathode wires 157 and 158 and the common anode wires 151 to 156 after the film member 120 is bonded onto the conductor pattern 172 and the resist pattern 171 formed on the substrate 110.

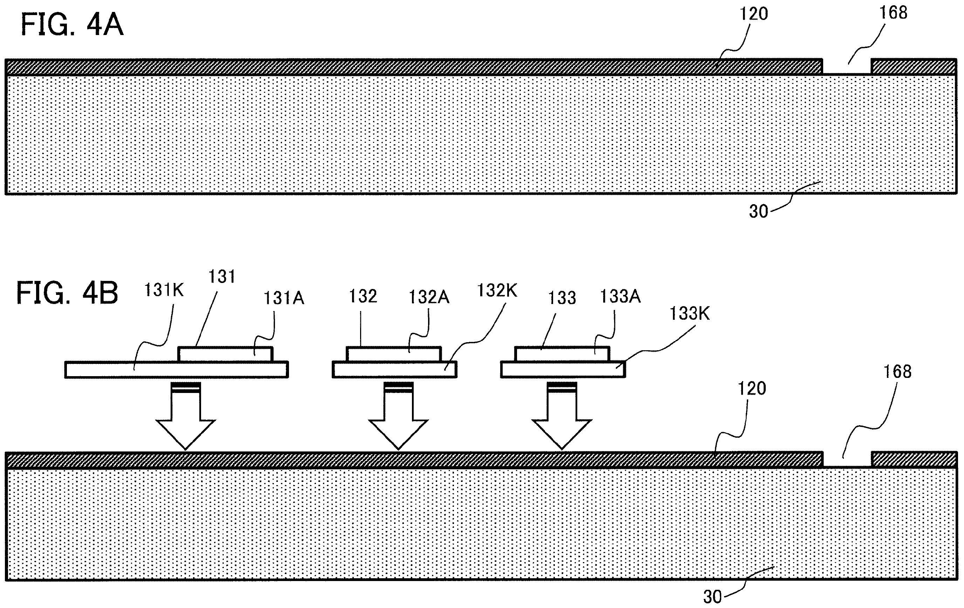

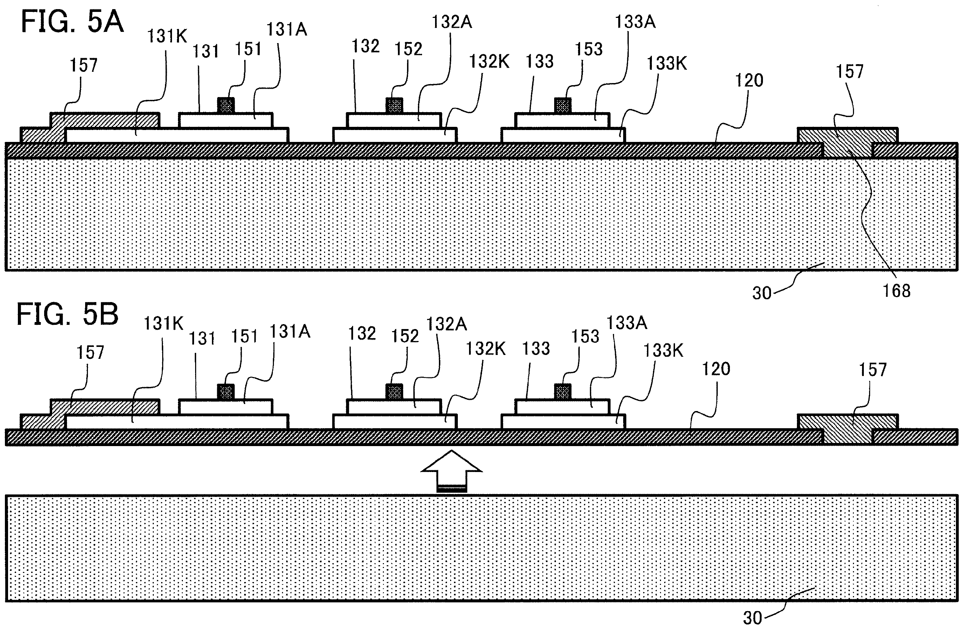

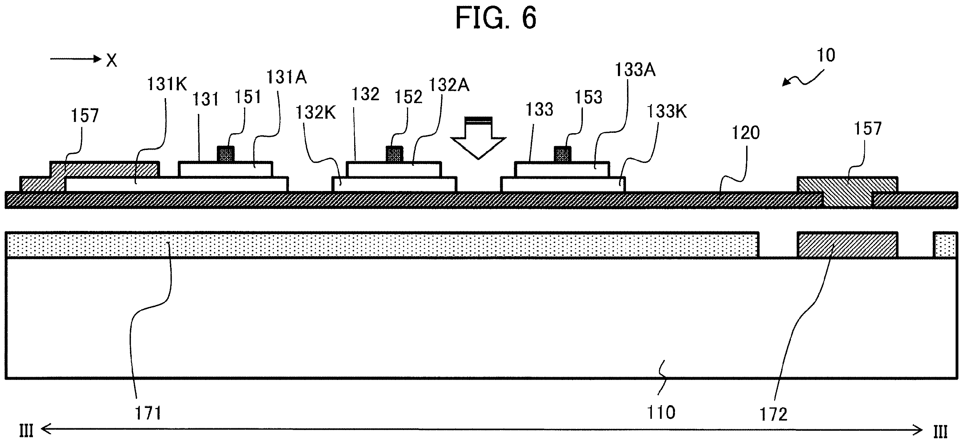

Figs. 4A and 4B are schematic cross-sectional views showing a manufacturing process of the LED display 10 according to the first embodiment (a process of forming the film member 120 and the LEDs 131, 132 and 133). Figs. 5A and 5B are schematic cross-sectional views showing the manufacturing process of the LED display 10 (a process of forming the common cathode wire 157 and moving the film member 120). Fig. 6 is a schematic cross-sectional view showing the manufacturing process of the LED display 10 according to the first embodiment (a process of bonding the film member 120 onto the substrate 110).

As shown in Fig. 4A, first, the film member 120 made of organic or inorganic material is formed on a support substrate 30 made of glass, silicon (Si) or the like, and thereafter the contact via 168 and the contact vias 161 to 167 (shown in Fig. 2) as openings for contact are formed by a publicly known etching technology.

Subsequently, as shown in Fig. 4B, the LEDs 131, 132 and 133 for R, G and B that have been grown on a growth substrate (not shown) different from the support substrate 30 are peeled off from the growth substrate, moved to the film member 120 formed on the support substrate 30, and joined onto the film member 120. Incidentally, while the LEDs 131, 132 and 133 are joined onto the film member 120 in Fig. 4B after performing processing for exposing the cathode layers 131K, 132K and 133K, it is also possible to perform the processing of the anode layers 131A, 132A and 133A and the cathode layers 131K, 132K and 133K after the bonding onto the film member 120.

Subsequently, as shown in Fig. 5A, the common anode wires 151 to 153 (the common anode wires 154 to 156 are shown in Fig. 2) and the common cathode wire 157 (the common cathode wire 158 is shown in Fig. 2), connecting the anode layers 131A, 132A and 133A and the cathode layers 131K, 132K and 133K of the LEDs 131, 132 and 133 for R, G and B to the corresponding contact vias, are formed. Incidentally, although not shown in Fig. 5A, it is also possible to form a contact material, for the purpose of reducing contact resistance or the like, between the anode layers 131A, 132A and 133A and the common anode wires 151 to 153 or between the cathode layers 131K, 132K and 133K and the common cathode wires 157 and 158.

Subsequently, the film member 120 is peeled off from the support substrate 30 as shown in Fig. 5B, and as shown in Fig. 6, the film member 120 is bonded onto the substrate 110 on which the conductor pattern 172 corresponding to the contact vias of the film member 120 has been formed. Incidentally, while the contact via 168 of the film member 120 in Fig. 6 has previously been filled in with wiring (the common cathode wire 157), it is also possible to form the electrical connection between the wiring on the film member 120 and the electrode (e.g., the conductor pattern 172) exposed in the contact via by first joining the film member 120, with the contact via 168 left open, to the substrate 110 and thereafter filling in the contact via with solder, conductive ink or the like. By the process described above, the light emitting device shown in Fig. 3 is formed.

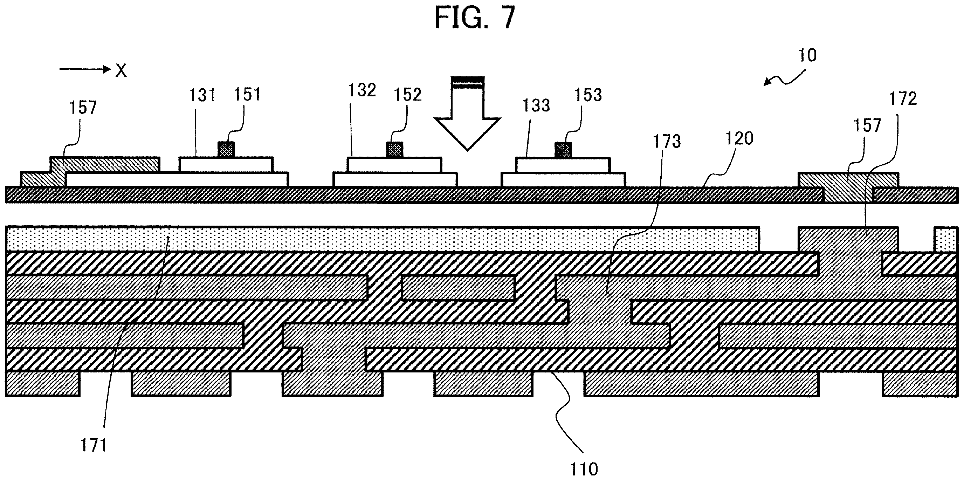

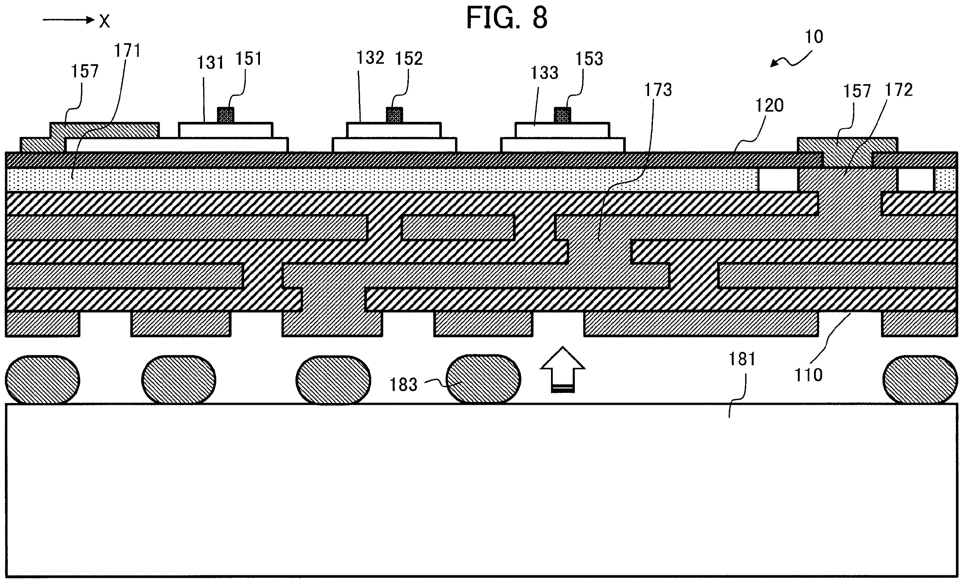

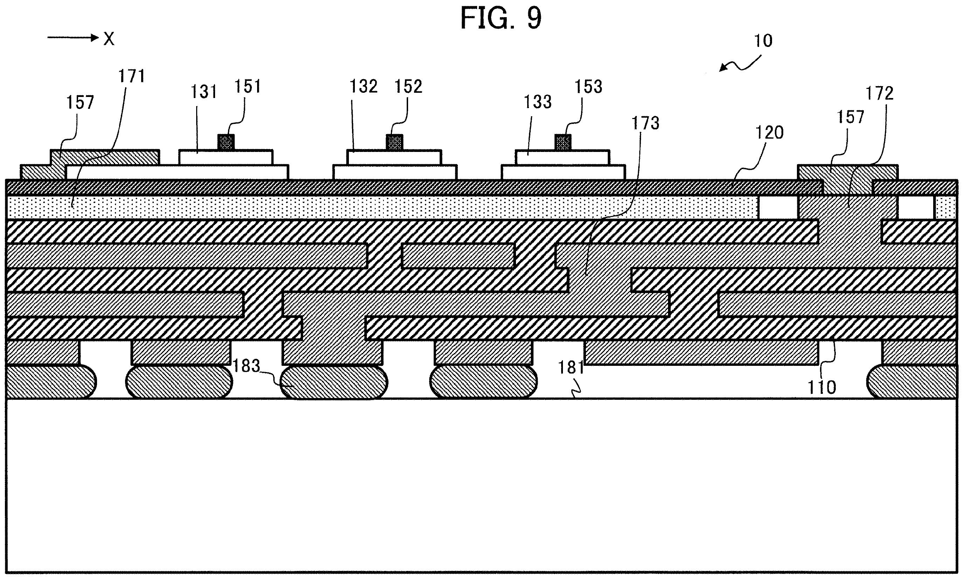

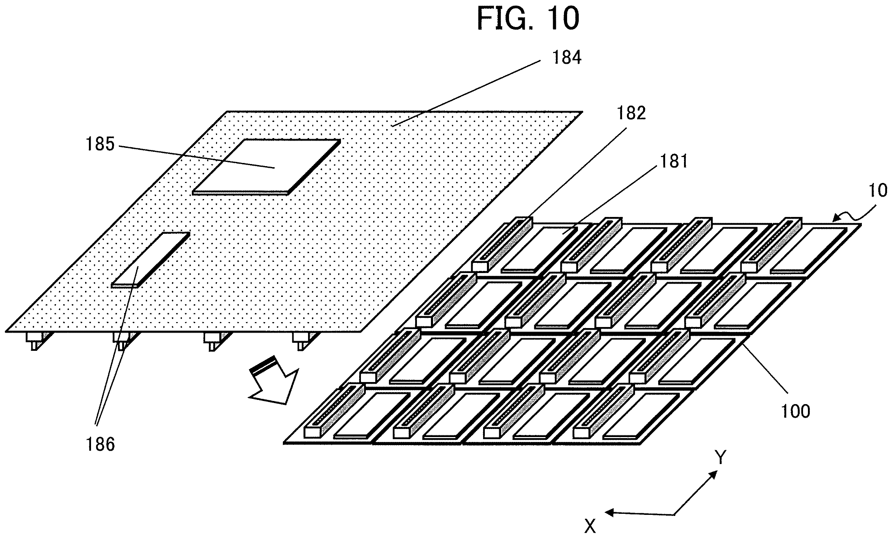

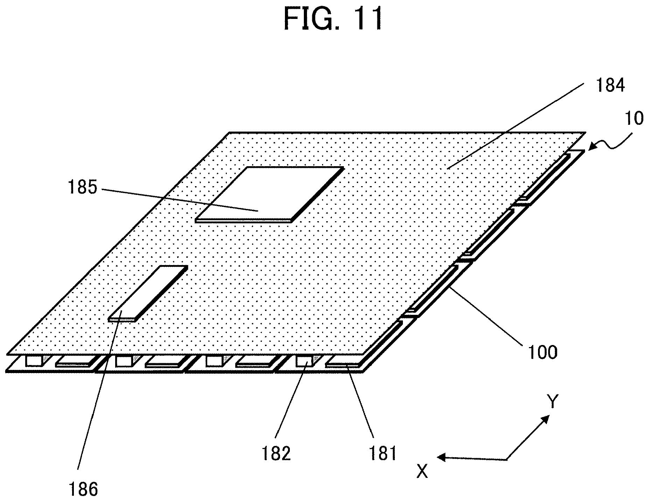

Fig. 7 is a schematic cross-sectional view showing an example of the structure of the conductor pattern 172 and wiring 173 of the substrate 110 in the process of Fig. 6. Fig. 8 is a schematic cross-sectional view showing a process of connecting driver ICs 181 to the LED display 10 manufactured by the process of Fig. 7. Fig. 9 is a schematic cross-sectional view showing the LED display 10 to which the driver ICs 181 have been connected. Fig. 10 is a schematic cross-sectional view showing a state before the LED display 10 to which the driver ICs 181 have been connected and a panel control substrate 184 are coupled together. Fig. 11 is a schematic cross-sectional view showing a state after the LED display 10 to which the driver ICs 181 have been connected and the panel control substrate 184 are coupled together.

As shown in Fig. 10 and Fig. 11, a back side of the LED display 10 is provided with the driver ICs 181 and connectors 182. The panel control substrate 184 is provided with a panel control element 185 for controlling a plurality of LED displays and connectors 186 to be connected to the connectors 182.

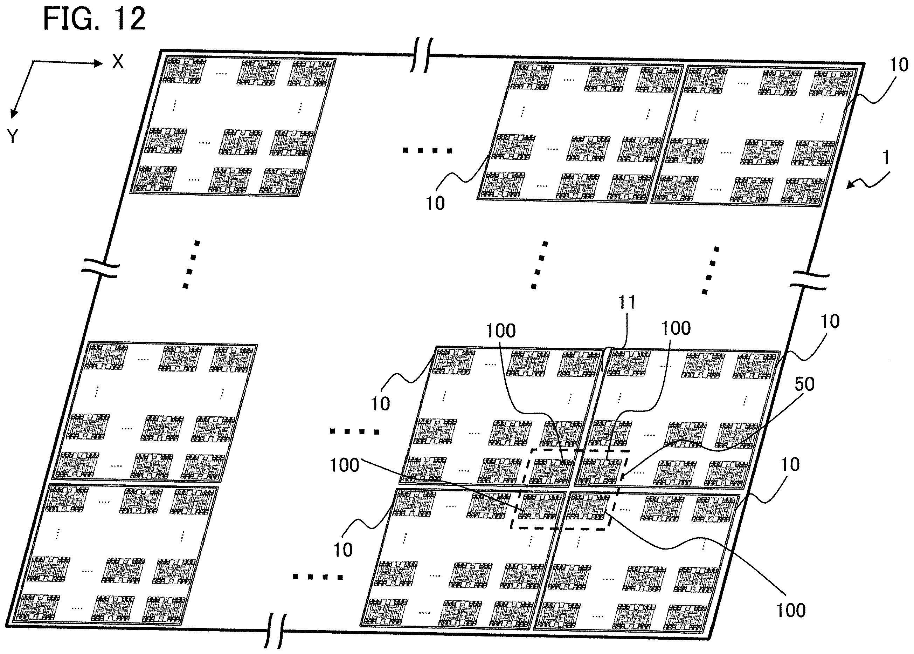

Fig. 12 is a schematic perspective view showing an image display device 1 including a plurality of LED displays 10 arranged in a grid. As shown in Fig. 12, the image display device 1 includes a plurality of LED displays 10 arranged in a grid.

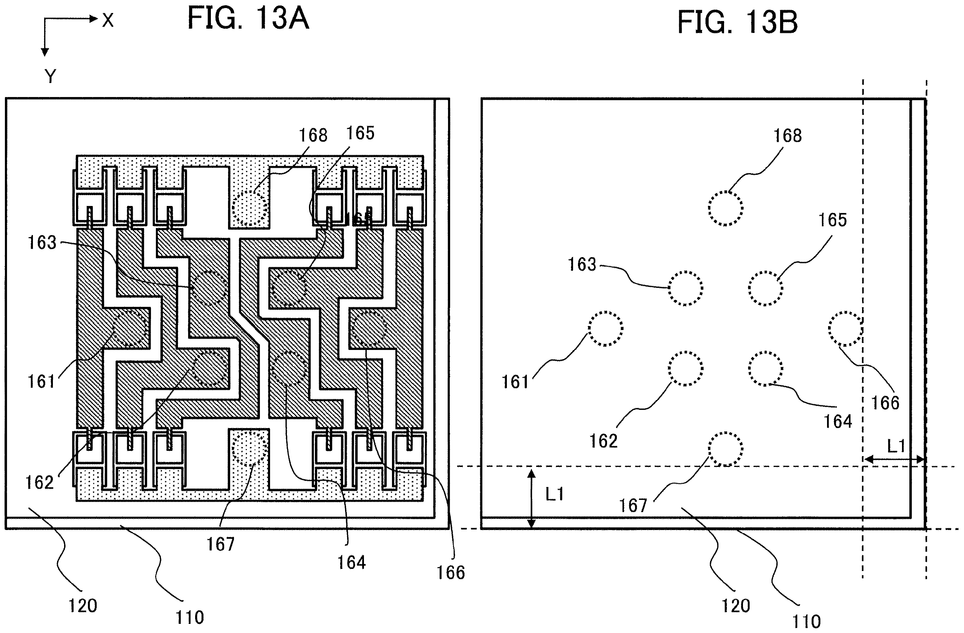

Figs. 13A and 13B are schematic plan views showing the contact vias 161 to 168 in the light emitting device (i.e., one pixel set unit 100) shown in Fig. 2. Fig. 13B excerpts the contact vias 161 to 168 from Fig. 13A. As shown in Figs. 13A and 13B, even if LEDs for R, G and B are arranged in the vicinity of the outer periphery of the substrate 110, the contact vias 161 to 168 are arranged at least a distance L1 inside from an edge (i.e., side) of the substrate 110, and thus the conductor pattern 172 on the substrate 110 corresponding to the contact vias 161 to 168 is also arranged at least the distance L1 inside from the edge (i.e., side) of the substrate 110.

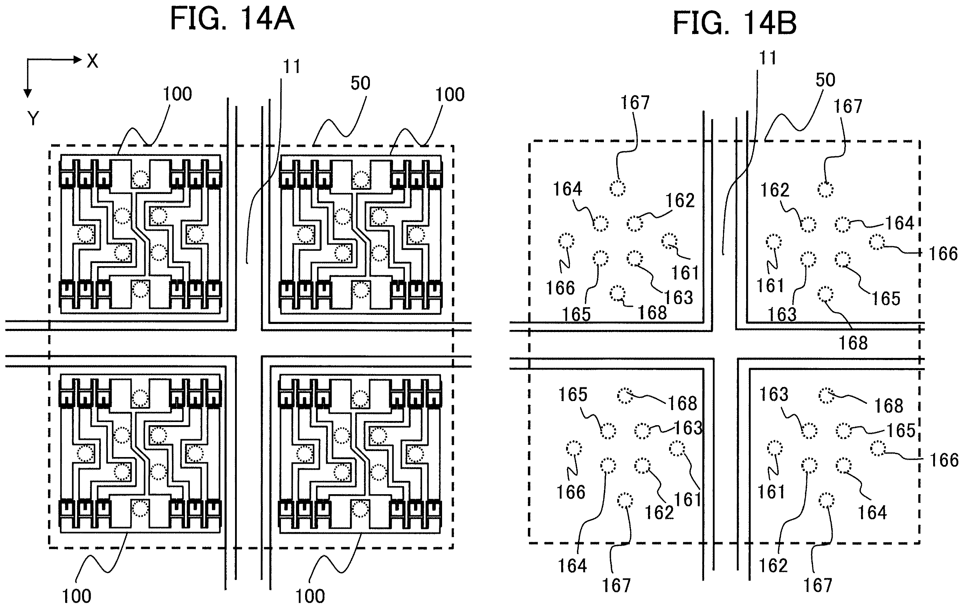

Figs. 14A and 14B are schematic plan views showing the contact vias 161 to 168 of four light emitting devices (pixel set units 100) adjoining each other in four LED displays 10 adjoining each other in the image display device 1 shown in Fig. 12. Figs. 14A and 14B show a cross-shaped region 11 between the adjoining LED displays 10 shown in Fig. 12. Fig. 14B excerpts the contact vias 161 to 168 in Fig. 14A. As shown in Figs. 14A and 14B, even if LEDs for R, G and B are arranged to the vicinity of the outer periphery of each LED display 10, the contact vias 161 to 168 are arranged inside from the edge of the substrate 110, and thus the adjoining LED displays 10 can be arranged in close proximity to each other.

As described above, according to the first embodiment, it becomes possible to arrange LEDs in the vicinity of the edge of the LED display 10, by which an LED display 10 of a narrow pitch can be realized.

Especially in the case where the contact vias 161 to 168 are provided in the quadrangle formed by the straight lines 301 to 304 connecting the outer peripheries of the four pixels 101 to 104 closest to the corner parts 100a to 100d and included in the pixel set unit 100, it becomes possible to arrange LEDs in the vicinity of the edge of the LED display 10 and an LED display 10 of a still narrower pitch can be realized.

Further, also in cases of forming the image display device 1 in which a plurality of LED displays 10 are arranged in a grid (i.e., in a tile pattern) as shown in Fig. 14A, it becomes possible to arrange a plurality of LED displays 10 at narrow pitches, and an image display device 1 in which seams are inconspicuous can be realized.

### (Second Embodiment)

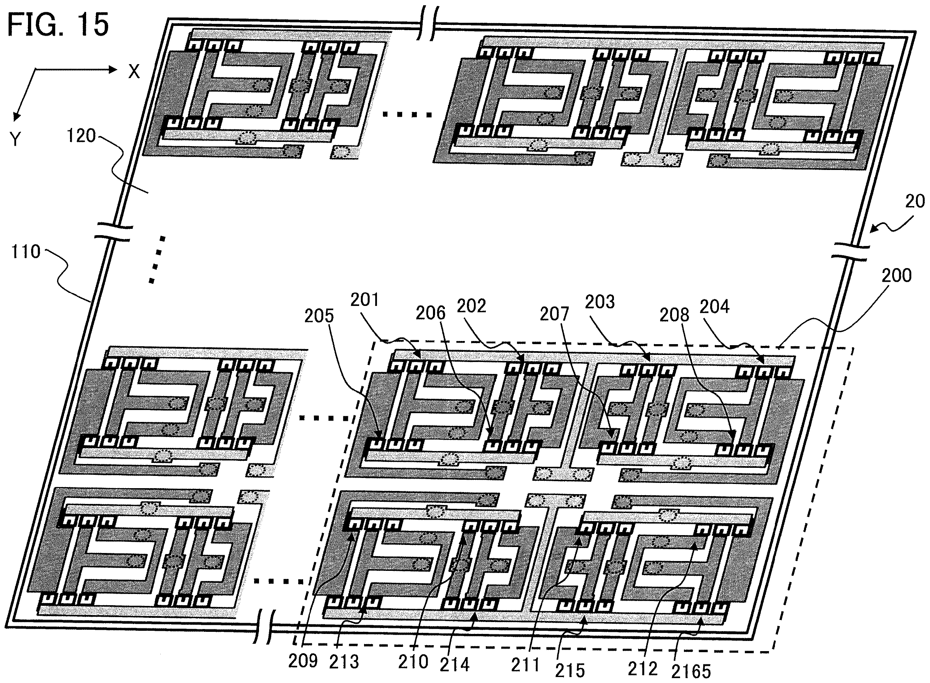

Fig. 15 is a schematic perspective view showing an LED display 20 as a light emitting display according to a second embodiment. As shown in Fig. 15, the LED display 20 includes a plurality of pixel set units 200 (i.e., a plurality of light emitting devices) arranged two-dimensionally on the film member 120. In the LED display 20 according to the second embodiment, the plurality of pixels included in each pixel set unit 200 are sixteen pixels 201 to 216 arranged in a grid of four rows and four columns.

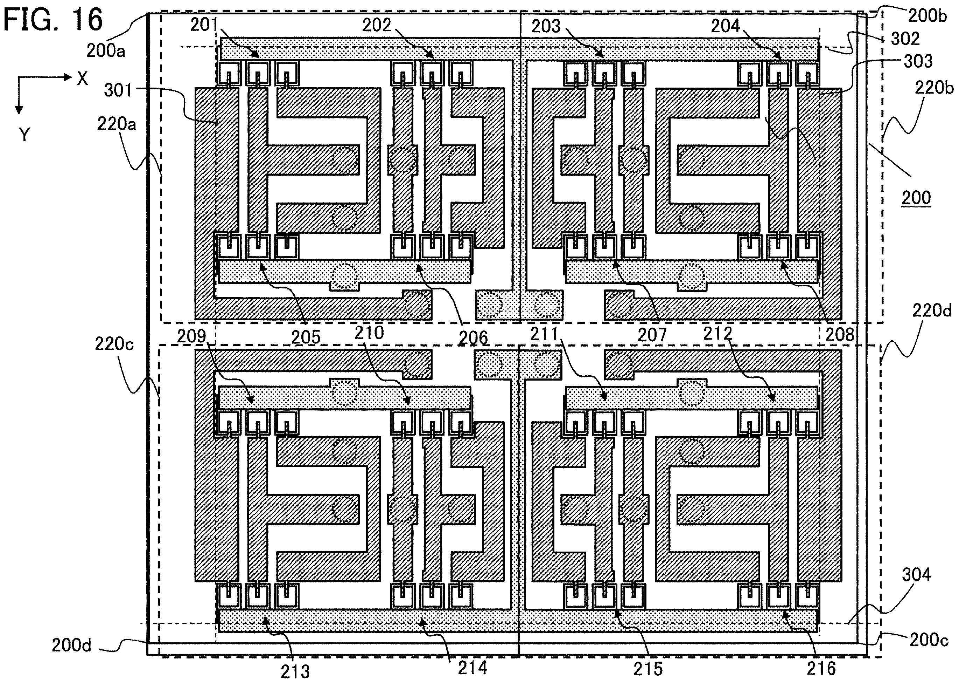

Fig. 16 is a schematic plan view showing the pixel set unit 200 (including four pixel subset units 220a to 220d) according to the second embodiment. Each pixel subset unit 220a - 220d includes four pixels arranged in two rows and two columns. The pixel subset units 220a and 220b (or 220c and 220d) adjoining in the X direction (horizontal direction in Fig. 16) have structure line-symmetrical with each other with respect to a straight line in the Y direction as a symmetry axis. The pixel subset units 220a and 220c (or 220b and 220d) adjoining in the Y direction (vertical direction in Fig. 16) have structure line-symmetrical with each other with respect to a straight line in the X direction (horizontal direction in Fig. 16) as a symmetry axis.

Contact vias 267 and 268 as first contact vias and contact vias 261 to 266 as second contact vias are provided in a quadrangle formed by straight lines 301 to 304 connecting outer peripheries of four pixels 201, 204, 213 and 216 closest to corner parts 200a to 200d of the pixel set unit 200 among the plurality of pixels 201 to 216 included in the pixel set unit 200.

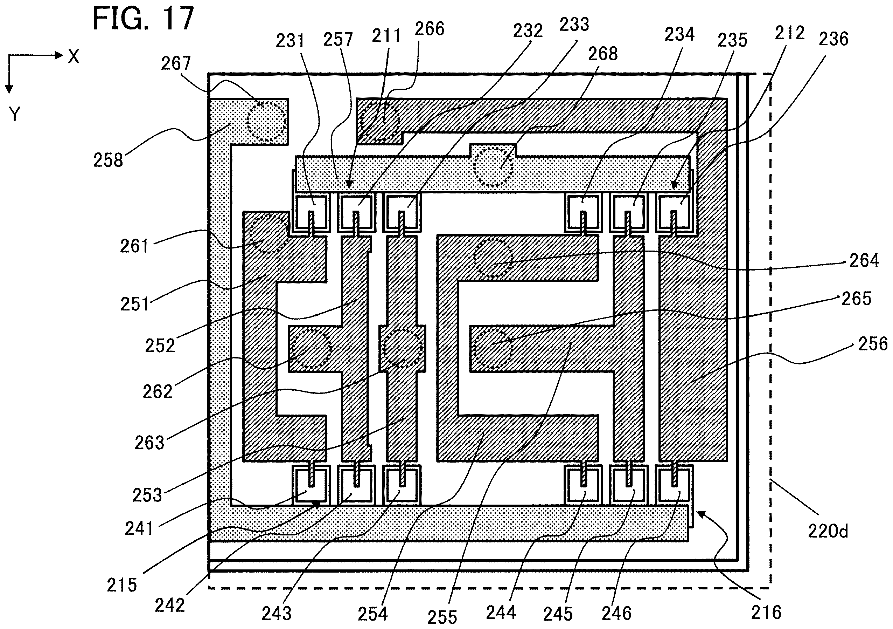

Fig. 17 is a schematic plan view showing the pixel subset unit 220d shown in Fig. 16. In the pixel subset unit 220d, the contact vias 261 to 268 are arranged around one pixel 211 among the four pixel 211, 212, 215 and 216 forming one pixel subset unit 220d. Further, in the pixel subset unit 220d, common cathode wires 257 and 258 and common anode wires 251 to 256 are arranged without intersecting with each other similarly to the first embodiment. Furthermore, in the pixel set unit 200, each pixel 201 - 216 includes three LEDs 231 to 233 (or 234 to 236, or 241 to 243, or 244 to 246) for R, G and B aligned in the X direction similarly to the first embodiment.

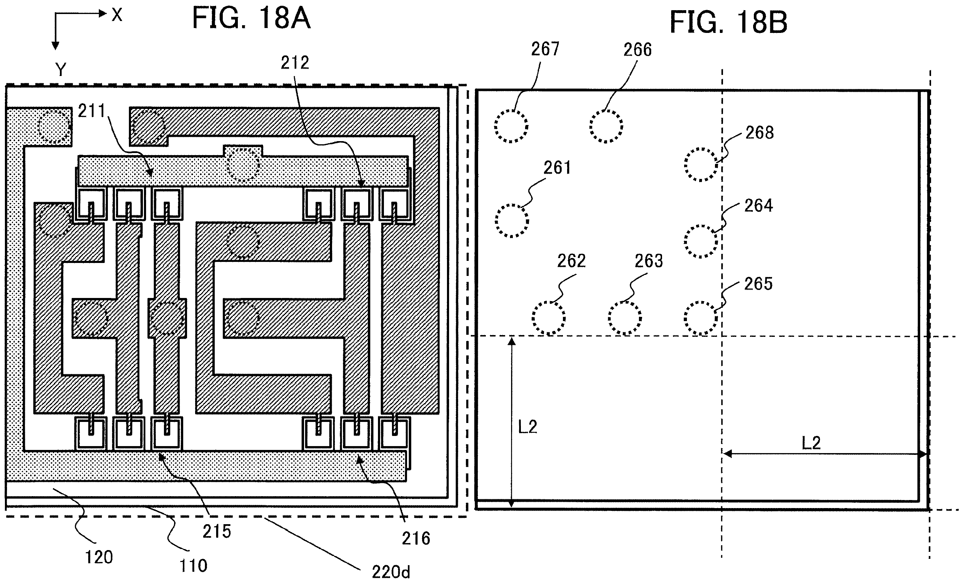

Figs. 18A and 18B are diagrams showing the contact vias 261 to 268 in the pixel subset unit 220d shown in Fig. 17. As shown in Fig. 15 and Fig. 16, the contact vias 261 to 268 in each of the pixel subset units 220a to 220d can be arranged in a quadrangular region formed by the straight lines 301 to 304 connecting the outer sides of the outermost four pixels 201, 204, 216 and 213 of one pixel set unit 200.

As described above, according to the second embodiment, it becomes possible to arrange LEDs in the vicinity of the edge of each LED display 20, by which an LED display 10 of a narrow pitch can be realized. Further, according to the second embodiment, an LED display of a still narrower pitch can be realized in comparison with the first embodiment.

Especially in the case where the contact vias 261 to 268 are provided in the quadrangle formed by the straight lines 301 to 304 connecting the outer peripheries of the four pixels 201, 204, 213 and 216 closest to the corner parts 200a to 200d and included in the pixel set unit 200, it becomes possible to arrange LEDs in the vicinity of the edge of the LED display 20 and an LED display 20 of a still narrower pitch can be realized.

Further, also in cases of forming an image display device in which a plurality of LED displays 20 are arranged in a grid (i.e., in a tile pattern), it becomes possible to arrange a plurality of LED displays 20 at narrow pitches, and an image display device in which seams are inconspicuous can be realized.

Furthermore, since the contact vias 261 to 268 can be arranged sufficiently inside (i.e., at positions the distance L2 in Fig. 18B apart) from the outer periphery of the substrate 110 as shown in Fig. 18B, it is possible to realize an LED display 20 more superior in terms of the reliability or the cost.

Except for the features described above, the second embodiment is the same as the first embodiment.

### (Description of Reference Characters)

1: image display device, 10, 20: LED display (light emitting display), 100, 200: pixel set unit (light emitting device), 100a - 100d, 200a - 200d: corner part, 101 - 104, 201 - 216: pixel, 110: substrate, 120: film member, 151 - 156, 251 - 256: common anode wire (second common wiring), 157, 158, 257, 258: common cathode wire (first common wiring), 131 - 135, 141 - 145, 231 - 235, 241 - 245: LED (light emitting element), 161 - 166, 261 - 266: contact via (second contact via), 167, 168, 267, 268: contact via (first contact via), 301 - 304: straight line.

## Claims

1. A light emitting device comprising:
a pixel set unit (100, 200) that includes a plurality of pixels (101-104, 201-216) arranged in a grid;
first common wiring (157, 158, 257, 258) that connects together first terminals of pixels aligned in a first direction among the plurality of pixels; and
second common wiring (151-156, 251-256) that connects together second terminals of two pixels (101, 102 / 103, 104) aligned in a second direction orthogonal to the first direction among the plurality of pixels (101-104, 201-216).

2. The light emitting device according to claim 1, further comprising a film member (120), wherein
the first common wiring (157, 158, 257, 258) and the second common wiring (151-156, 251-256) are arranged on the film member (120), and
the first common wiring (157, 158, 257, 258) and the second common wiring (151-156, 251-256) are formed without intersecting with each other.

3. The light emitting device according to claim 2, further comprising a substrate (110) including a first electrode and a second electrode, wherein
the film member (120) includes a first contact via (167, 168) as a through hole for connecting the first common wiring (157, 158, 257, 258) and the first electrode and a second contact via (161-166) as a through hole for connecting the second common wiring and the second electrode, and
the first contact via (167, 168) and the second contact via (161-166) are arranged in a quadrangle formed by straight lines (301-304) connecting outer peripheries of four pixels closest to corner parts of the pixel set unit (100, 200) among the plurality of pixels included in the pixel set unit (100, 200).

4. The light emitting device according to any one of claims 1 to 3, wherein the plurality of pixels included in the pixel set unit (100) are four pixels (101-104) arranged in two rows and two columns.

5. The light emitting device according to any one of claims 1 to 3, wherein the plurality of pixels included in the pixel set unit (200) are sixteen pixels (201-216) arranged in four rows and four columns.

6. The light emitting device according to claim 5, wherein
the pixel set unit (200) includes four pixel subset units arranged in two rows and two columns, and
each of the pixel subset units includes four pixels (201, 202, 205, 206 / 203, 204, 207, 208) arranged in two rows and two columns as the plurality of pixels.

7. The light emitting device according to claim 6, wherein
pixel subset units adjoining in the first direction among the four pixel subset units have structure line-symmetrical with each other with respect to a straight line in the second direction as a symmetry axis, and
pixel subset units adjoining in the second direction among the four pixel subset units have structure line-symmetrical with each other with respect to a straight line in the first direction as a symmetry axis.

8. The light emitting device according to any one of claims 1 to 7, wherein each of the plurality of pixels (101-104, 201-216) includes a plurality of light emitting elements (131-135, 141-145, 231-235, 241-245).

9. The light emitting device according to claim 8, wherein the plurality of light emitting elements include a light emitting element (121, 131) for red color, a light emitting element (122, 132) for green color and a light emitting element (123, 133) for blue color.

10. The light emitting device according to claim 8 or 9, wherein
the first terminals of the pixels aligned in the first direction are cathode terminals of light emitting elements (131-135 / 141-145 / 231-235 / 241-245) aligned in the first direction among the plurality of light emitting elements, and
the second terminals of the two pixels aligned in the second direction are anode terminals of two light emitting elements (131, 141 / 231, 241) facing each other in the second direction among the plurality of light emitting elements.

11. The light emitting device according to claim 8 or 9, wherein
the first terminals of the pixels aligned in the first direction are anode terminals of light emitting elements aligned in the first direction among the plurality of light emitting elements, and
the second terminals of the two pixels aligned in the second direction are cathode terminals of two light emitting elements facing each other in the second direction among the plurality of light emitting elements.

12. A light emitting display (10, 20) comprising a plurality of the light emitting devices according to any one of claims 1 to 11 that are arranged in a grid.

13. An image display device (1) comprising a plurality of the light emitting displays (10, 20) according to claim 12 that are arranged in a grid.
